# EUROPEAN PATENT APPLICATION

(11) **EP 4 633 349 A1**
(43) Date of publication of application: **15.10.2025**
(21) Application number: 25168534.3
(22) Date of filing: 04.04.2025
(51) Int. Cl.: H10N 50/10, H10N 50/80, H10N 50/85

(54) **MAGNETIC DEVICE AND MEMORY CELL**

(30) Priority: 12.04.2024 CN 202410441522
(71) Applicant: LoMaRe Technologies Limited, London EC3R 7LP (GB); LoMaRe Chip Technology Changzhou Co., Ltd., Changzhou City, Jiangsu Province (CN)
(72) Inventor: ZEMEN, Jan, London, EC3R 7LP (GB); DOLUI, Kapildeb, London, EC3R 7LP (GB); ZOU, Bin, London, EC3R 7LP (GB); MIHAI, Andrei Paul, London, EC3R 7LP (GB)
(74) Representative: Mathys & Squire

(57) **Abstract**

Disclosed is a magnetic device (100) comprising: a spacer layer (110); a first magnetic electrode layer (121) located on one side of the spacer layer; and a second magnetic electrode layer (122) located on the other side of the spacer layer; the spacer layer comprises a perovskite nitride material or perovskite oxynitride material; the first magnetic electrode layer and the second magnetic electrode layer respectively comprises a metallic antiperovskite nitride material; the relative net magnetization orientation of the first magnetic electrode layer and the second magnetic electrode layer is switchable between a parallel net magnetization state or an antiparallel net magnetization state to control a spin-polarised current therethrough. Also disclosed is a memory cell comprising the magnetic device, wherein the data is recordable as a parallel or antiparallel net magnetization state of the first magnetic electrode layer and the second magnetic electrode layer of the magnetic device.

## Description

### Technical Field

The invention relates generally to a magnetic device for memory, preferably including perovskite-based electrode materials, and to a memory cell or memory including the magnetic device.

### Background to the Invention

Established random access memory (RAM) technologies such as static RAM (SRAM) and dynamic RAM (DRAM) suffer from loss of data when disconnected from a power supply, i.e. volatility. Refreshing the state of RAM contributes to high energy consumption of data centres and modern computing in general. There is thus great interest in developing non-volatile RAM (NVRAM) technologies that are able to retain their data even when disconnected from a power source.

Non-volatile magnetic RAM (MRAM) is an emerging technology that has the potential to replace conventional RAM technologies (like DRAM and NAND flash) and revolutionize the field of memory storage. While MRAM offers numerous advantages such as non-volatility, high endurance, and fast read/write speeds, there remain several challenges that need to be addressed for its widespread adoption, including scalability, power consumption, temperature dependence, and cost.

The most promising MRAM technologies at present are based on spin-transfer torque switching (STT-MRAM). However, mass adoption of STT-MRAM has been hindered to date by high switching current densities (i.e. high-power consumption), limited thermal stability (restricting applications at high temperatures), as well as sensitivity to external magnetic fields and relatively low ON/OFF ratios in existing devices which consequently limits the scalability of memory bits.

There is thus a need for improved MRAM technologies which address at least some of the challenges with state-of-the-art STT-MRAM.

### Summary of the Invention

To overcome the above technical shortcomings in the prior art, the present invention provides a magnetic device and a memory cell with the aim of solving the problems of existing magnetic device such as high-power consumption, poor thermal stability, and limited scalability.

According to a first aspect of the present invention, there is provided a magnetic device for non-volatile memory or storage. The device comprises a spacer layer; a first magnetic electrode layer on one side of the spacer layer; and a second magnetic electrode layer on the other side of the spacer layer, wherein the relative (net) magnetisation orientation of the first and second magnetic electrode layers (i.e. relative to each other) is switchable between a parallel and antiparallel (net magnetisation) state to control a spin-polarised current through the device. The spacer layer is formed of or comprises a perovskite-like/perovskite-based nitride material or a perovskite oxynitride material, and the first magnetic electrode layer and second magnetic electrode layer comprise a metallic antiperovskite nitride material.

The device is based on an active tri-layer of two magnetically ordered electrode layers (i.e. first magnetic electrode layer and second magnetic electrode layer) and a spacer layer separating the first magnetic electrode layer and second magnetic electrode layer, and is thus referred to as a magnetic device. The spacer layer can be a conductive spacer, in which case the device can operate as a spin valve, or a tunnel barrier in which case the device can operate as a magnetic tunnel junction (MTJ). Further, the spacer layer may be non-magnetic, or it may be magnetic. All three layers share the same antiperovskite/perovskite lattice structure and all three layers are nitrides (which can be conductive or insulating) or contain at least some nitrogen. The magnetic electrodes provide highly spin polarised conduction channels, but the challenge is maintaining a high spin polarisation across the interfaces with the spacer layer to provide high magnetoresistance (giant magnetoresistance, GMR, in the case of a spin valve configuration and tunnelling magnetoresistance, TMR, in the case of a MTJ configuration). The all-perovskite all-nitride structure of the tri-layer provides a novel and scalable solution to achieving high GMR/TMR and addressing challenges in current STT-MRAM technologies. The all-perovskite structure provides high mechanical stability and good lattice match between the individual layers which promotes high quality interfaces and endurance. Meanwhile, the all-nitride nature of the tri-layer provides a less abrupt change in the lattice constituents at the interfaces between electrode layers and the spacer layer. The resulting low lattice disorder at the electrode-spacer interfaces ensures low scattering and high spin coherence which contributes to maintaining a high spin polarization of the current across the interfaces. This, combined with efficient k-filtering in the spacer layer, can provide high GMR or TMR. In the field of magnetic devices, a high GMR can be considered to be anything over 100% and a high TMR can be considered to be anything over 1000%.

Further, the device takes advantage of the properties of perovskite-like materials whereby the position of the Fermi level in the device and the conductivity of the spacer layer can be controlled by the composition of each layer. Thereby, the TMR or GMR for a given junction can be maximised by tuning chemical composition without changing the lattice structure or magnetic structure.

In this context, the term perovskite-like or perovskite-based means the material can be a perovskite or an antiperovskite because the perovskite and antiperovskite lattice structure is identical, the only difference being that the positions of the anion and cation constituent elements is reversed in the unit cell.

The first magnetic electrode layer and second magnetic electrode layer have an ordered magnetic state (i.e. not paramagnetic), which is preferably ferrimagnetic or antiferromagnetic (in the ground, unstrained state). Ferrimagnetic or antiferromagnetic electrodes have high perpendicular magnetic anisotropy (PMA) and low net magnetisation which ensures low sensitivity to external magnetic fields, low dipolar coupling between neighbouring devices (i.e. in high density arrays), and high thermal stability even at small lateral dimensions, making the device highly scalable. This, combined with a high GMR/TMR, makes the device particularly advantageous for non-volatile memory applications.

In an embodiment the spacer layer is a conductive spacer layer formed of or comprising a conductive perovskite-based nitride material (whereby "conductive" includes metallic or semiconducting materials, but not insulating materials). This can be referred to as a spin valve configuration of the device.

Preferably, the spacer layer may be formed/comprised of or comprise a conductive antiperovskite nitride material of the form Cu₃D_{z}N_{1-y}, where D is a corner site element selected from a group comprising: Pd, Rh, Ru, Cu, Ag, Al, Au, Co, Cu, Fe, Ga, Ge, In, Ir, Mn, Ni, Pt, Sb, Si, Sn, and Zn, and where 0 ≤ z ≤ 1, 0 ≤ y < 1.

Here a "corner site" refers to the position of the element in the antiperovskite crystal lattice, and z is a compositional parameter that indicates the occupancy of the element in the lattice. The "occupancy" of the corner sites refers to the proportion or fraction of corner lattice sites, averaged over the layer, that are occupied by the element (e.g. z = 0 means none of the corner sites in the layer are occupied by the element, and while z = 1 means all of the corner sites in the layer are occupied by the element).

Cu₃D_{z}N_{1-y} is a thermodynamically stable non-magnetic metallic antiperovskite nitride with excellent k-filtering properties, suitable for achieving high MR. The band structure and conductance of Cu₃D_{z}N_{1-y} can be varied through the occupancy of corner site elements D during deposition to tune the MR. This compound is also advantageous from a manufacturing point of view as copper (Cu) is an abundant and relatively cheap material, and Cu₃D_{z}N_{1-y} can be readily prepared by common deposition techniques, such as magnetron sputtering (physical vapour deposition).

Optionally or preferably, the spacer layer is terminated at the interface with the first magnetic electrode layer and second magnetic electrode layer by a Cu-D layer. This termination layer is advantageous for maintaining high spin polarisation at the interface with the electrodes and thus high MR.

Preferably, where z > 0 the element D is Pd. In a preferred embodiment, the spacer layer may be formed/comprised of or comprise Cu₃N or Cu₃PdN. In this case, preferably the spacer layer is terminated at the interface with the first magnetic electrode layer and second magnetic electrode layer by a Cu or a Cu-Pd layer respectively.

Alternatively, the spacer layer may be formed/comprised of or comprises a conductive perovskite nitride material of the form DReN_{3-y},where 0 ≤ y ≤ 1, D is a rare earth element selected from a group comprising: La, Ce, Pr, Nd, Pm, Sm, Eu, Gd, Tb, Dy, Ho, Er, Tm, Yb and Lu. For instance, the spacer layer may be formed/comprised of or comprise DReN₃, where D is a rare earth element from the same list as above.

The compound family DReN_{3-y} is another perovskite nitride that includes metallic and semiconducting materials and which also have good k-filtering properties suitable for achieving high MR.

Preferably, where the spacer layer is conductive (i.e. the spin valve configuration), it has a thickness of 20 nm or less, more preferably 5 nm or less. The spacer layer may have a thickness of at least 1 nm.

In an alternative embodiment, the spacer layer is a tunnel barrier formed/comprised of or comprising an insulating/non-conductive perovskite nitride material or an insulating/non-conductive oxynitride perovskite material (whereby insulating/non-conductive means that the Fermi energy lies within the band gap so as to present a potential barrier for transport across the spacer layer). This can be referred to as a magnetic tunnel junction (MTJ) configuration of the device. In this case, the spacer layer may be referred to as a barrier layer.

In this context, an oxynitride refers to a perovskite material comprising oxygen and nitrogen in some proportion or composition. An oxynitride may be a nitrogen-substituted perovskite oxide material or a nitrogen-substituted oxide material (i.e. wherein the substitution element typically has a relatively small occupancy compared to the element it is substituting).

Preferably, the barrier layer may be formed/comprised of or comprise a (insulating) perovskite oxynitride material of the form SrTiO_{3-z}N_{z} or DFeO_{3-z}N_{z}, where D is a rare earth element selected from a group comprising: La, Ce, Pr, Nd, Pm, Sm, Eu, Gd, Tb, Dy, Ho, Er, Tm, Yb and Lu, and where 0 ≤ z ≤ 3. Preferably, 0 ≤ z ≤ 1. The material family DFeO_{3-z}N_{z} are rare-earth orthoferrites which are mostly antiferromagnetic insulators and can provide spin-filtering when used as tunnel barrier.

Aside from improving the spin polarisation (e.g. of the current and the ground state band structure) at the interfaces with the electrode layers, the introduction of nitrogen in the perovskite oxide material can advantageously be used to control the band gap, k-filtering and transport properties of the barrier layer to tune the MR. It also reduces the amount of oxygen in the barrier layer which reduces the amount of oxygen diffusion into the electrode layers. Oxygen diffusion into the electrodes is a problem in current state-of-the-art MTJ devices which overtime can corrode the metallic electrodes while at the same time leads to the formation and propagation of oxygen vacancies in the barrier layer, which degrades the device performance. In the present invention, this effect is (at least partially) suppressed by the substitution of oxygen with nitrogen. By analogy, it also supresses nitrogen diffusion into the barrier layer.

Preferably, the barrier layer may be formed/comprised of or comprise a perovskite oxide material SrTiO_{3-y} or DFeO_{3-y}, where 0 ≤ y ≤ 1, D is a rare earth element selected from a group comprising: La, Ce, Pr, Nd, Pm, Sm, Eu, Gd, Tb, Dy, Ho, Er, Tm, Yb and Lu. Preferably, the barrier layer may be formed/comprised of or comprise SrTiO₃ or DFeO₃ (y = 0), where D is as is a rare earth element from the same list as above.

Alternatively, the barrier layer may be formed/comprised of or comprise a (insulating) perovskite nitride material of the form DWN_{3-y}, where 0 ≤ y ≤ 1, D is a rare earth element selected from a group comprising: La, Ce, Pr, Nd, Pm, Sm, Eu, Gd, Tb, Dy, Ho, Er, Tm, Yb and Lu. Preferably, the element D is La. The barrier layer may be formed/comprised of or comprise DWN₃, where D is a rare earth element from the same list as above.

An insulating perovskite nitride is advantageous because it matches the lattice structure of the nitride electrodes thus helping to preserve spin polarisation at the interfaces, and it also does not contain oxygen thus supressing oxidation of the electrode layers.

Preferably, where the spacer layer is a tunnel barrier and insulting (i.e. the MTJ configuration), it has a thickness of 10 nm or less, preferably 3nm or less. And the spacer layer may have a thickness of at least 1 nm.

In an embodiment, the first magnetic electrode layer may be formed/comprised of or comprise a metallic antiperovskite nitride material of the form Mn₄₋ₓAₓN_{1-y}, and the second magnetic electrode layer may be formed/comprised of or comprise a metallic antiperovskite nitride material of the form Mn_{4-x'}A'_{x'}N_{1-y'}, where A and A' are a corner site element selected from a group comprising: Ag, Al, Au, Co, Cu, Fe, Ga, Ge, In, Ir, Ni, Pd, Pt, Rh, Sb, Si, Sn, Zn, and where 0 ≤ x,x' ≤ 1, and 0 ≤ y,y' < 1.

The Mn₄₋ₓAₓN_{1-y} family advantageously has highly spin polarised conduction channels, high Curie temperature, high magnetic anisotropy while keeping the saturation magnetization low to due to mutual compensation of the magnetic moments on the Mn atoms. In addition, the position of the Fermi energy and conductivity can be tuned through the composition (A, A'; x,x'; y, y').

Optionally or preferably, 0 ≤ x,x' ≤ 0.05. The magnetic structure and properties of the Mn₄₋ₓAₓN_{1-y}family can vary with the composition (x,x'). With Mn₄₋ₓAₓN_{1-y}, small substitutions of Mn (i.e. 0 ≤ x,x' ≤ 0.05) with element A, A' can advantageously tune the position of the Fermi energy and conductivity without significantly changing the electronic or magnetic structure. As such, small substitutions of Mn can be used to tune the spin polarisation of electronic states at the Fermi energy at the interface with the spacer layer and tune the change of interfacial density of states with (net) magnetisation state, which contributes to the MR.

Also, starting from Mn₄N, introducing small occupancies of A,A' can also further reduce the net magnetization (or even reach full compensation of the ferrimagnetic state, i.e. zero magnetization).

Preferably, the first magnetic electrode layer and second magnetic electrode layer are terminated at the interface with the spacer layer by a Mn-Mn-N layer. This termination layer advantageously allows a high spin polarisation of charge carriers to be maintained at the interface with the spacer layer, thus helping to maximise the MR.

Optionally or preferably, 0 ≤ y,y' ≤ 0.2. Introducing a nitrogen deficiency in one or both of the electrode layers can be used to tune the lattice matching between the electrodes and substrate, and to control the Curie/Neel temperature of the antiperovskite nitride, without changing the magnetic structure or lattice structure.

Preferably, A and A' are the same element. Optionally or preferably, the element A and/or A' is Ga.

In a preferred embodiment, the first magnetic electrode layer and second magnetic electrode layer comprise Mn₃GaN. Mn₃GaN has a fully compensated triangular antiferromagnetic order/structure in the bulk cubic (ground, unstrained) form (i.e. zero net magnetisation) and exhibits highly spin polarised states/conduction channels.

In another preferred embodiment, the first magnetic electrode layer and second magnetic electrode layer are formed/comprised of or comprise Mn₄N. Advantageously, compared to Mn₃GaN, Mn₄N has a higher Neel temperature T_{N} (approximately 700 Kelvin vs 300 Kelvin) and a higher magnetocrystalline anisotropy.

In an embodiment, the first magnetic electrode layer and/or second magnetic electrode layer may be strained (or under strain) to induce a collinear ferrimagnetic structure/order therein. This structure exhibits higher Curie/Neel temperature, magnetic anisotropy (MA) than the ground (unstrained) state, while keeping saturation magnetization low. In this case, preferably the first magnetic electrode layer and second magnetic electrode layer are formed/comprised of or comprise Mn₄N. For example, the ground state of Mn₄N is a non-collinear ferrimagnetic state which transforms to a collinear ferrimagnetic structure under strain. Mn₃GaN can also exhibit a collinear ferrimagnetic structure under strain at elevated temperatures, e.g. at or above 300 Kelvin. Specifically, the strain may be compressive or tensile strain. Preferably, the induced (in plane) compressive or tensile strain is up to 1% or up to 2%.

The induced collinear ferrimagnetic state may be present at temperatures at or above 200 Kelvin, at or above 290 Kelvin, or at or above 300 Kelvin.

Preferably, the device may further comprise a strain inducing layer for inducing a compressive or tensile strain in at least one of the first magnetic electrode layer and second electrode layer to thereby induce the collinear ferrimagnetic structure. The strain inducing layer is preferably adjacent first magnetic electrode layer or second magnetic electrode layer to induce a strain therein.

The strain inducing layer may be a layer comprised of a material having a lattice mismatch to the first magnetic electrode layer and/or second magnetic electrode layer (which is adjacent the strain inducing layer). The strain in the electrode layer adjacent the strain inducing layer may be greater than the strain in the other electrode layer. The strain inducing layer may be or comprise a substrate layer. The strain inducing layer or substrate may be formed of or comprise a conductive material or an insulating material. Where the strain inducing layer is insulating, it may comprise an opening through which the electrode layer adjacent the strain inducing layer can be electrically contacted (e.g. the opening may be produced by a subtractive etching process).

The strain inducing layer may be formed/comprised of or comprise BaₓSr₁₋ₓTiO₃ (0 ≤ x ≤ 1), BaZrₓTi₁₋ₓO₃ (0 ≤ x ≤ 1), PbZrₓTi₁₋ₓO₃ (0 ≤ x ≤ 1), SrRuO₃, Nb:SrTiO₃, LaAlO₃, (LaAlO₃)₃(Sr₂AlTaO₆)₇ (known as LSAT), (Pb(Mg_{0.33}Nb_{0.67})O₃)ₓ - (PbTiO₃)₁₋ₓ (known as PMN-PT, where 0.28 ≤ x ≤ 0.32), SrMoO₃, Cu₃PdN, MgO, Pt, Au, Pd or Si. In example implementations, the strain inducing layer may be SrTiO₃ or MgO.

Preferably, the first magnetic electrode layer and second magnetic electrode layer have a thickness of 100 nm or less, or 50 nm or less, or preferably 20 nm or less or 10 nm or less. The first magnetic electrode layer and second magnetic electrode layer may have a thickness in the range 50 nm to 10 nm.

Preferably the electrode layers and the spacer layer are sufficiently thin so that, where present, strain induced from the strain inducing later or substrate is maintained through the layer and their lattices do not fully relax.

Preferably, the space group of the spacer layer, and the first magnetic electrode layer and second magnetic electrode layer are the same (space group 221 in the case of the ideal cubic structure, or space group 123 if strained).

Preferably, a lattice mismatch between the spacer layer, and the first magnetic electrode layer and second magnetic electrode layer is less than ±10%, preferably less than ±1%.

According to a second aspect of the invention, there is provided a memory cell or memory or memory array comprising the magnetic device of the first aspect, wherein data or information is stored/recordable as a parallel and antiparallel (net magnetisation) state of the first magnetic electrode layer with respect to the second magnetic electrode layer. The memory is preferably a non-volatile memory cell or memory. One of the first magnetic electrode layer and second magnetic electrode layer is configured as a "free" magnetic electrode and the other is configured as a "fixed" magnetic.

According to a third aspect of the invention, there is provided a method of producing a magnetic device of the first aspect, wherein the first magnetic electrode layer comprises a metallic antiperovskite nitride material of the form Mn₄₋ₓAₓN_{1-y}, and wherein the second magnetic electrode layer comprises a metallic antiperovskite nitride material of the form Mn_{4-x'}A'_{x'}N_{1-y'}, the method comprising: selecting an element A and A' from a group comprising: Ag, Al, Au, Co, Cu, Fe, Ga, Ge, In, Ir, Ni, Pd, Pt, Rh, Sb, Si, Sn, Zn; selecting a value for x, x', y and y', where 0 ≤ x,x' ≤ 1, and 0 ≤ y,y' < 1, to tune the band structure so that the spin polarization of the electronic states at Fermi energy is maximized and the states available to tunnelling at both interfaces are mutually aligned (in reciprocal space) in the parallel state (low resistance).

According to another aspect of the invention, there is provided a magnetic device for non-volatile memory or storage. The device may be or comprise a magnetic tunnel junction device. The device comprises a barrier layer; a first magnetic electrode layer on one side of the barrier layer; and a second magnetic electrode layer on the other side of the barrier layer, wherein the relative (net) magnetisation orientation of the first magnetic electrode layer and second magnetic electrode layer is switchable between a parallel and antiparallel state to control a spin-polarised current through the device. The barrier layer is formed of or comprises an insulating perovskite nitride or oxide material, and the first magnetic electrode layer and second magnetic electrode layer comprise a metallic antiperovskite nitride material, preferably having a ferrimagnetic or antiferromagnetic structure (in the ground, unstrained state). The barrier layer may be non-magnetic material, or it may be magnetic.

Preferably, the barrier layer is formed of or comprises an insulating perovskite oxide material of the form SrTiO_{3-y} or DFeO_{3-y}, where 0 ≤ y ≤ 1 and D is a rare earth element selected from a group comprising: La, Ce, Pr, Nd, Pm, Sm, Eu, Gd, Tb, Dy, Ho, Er, Tm, Yb and Lu. Preferably, y = 0. Alternatively, the barrier layer may be formed of or comprise an insulating perovskite nitride material of the form DWN_{3-y}, where 0 ≤ y ≤ 1 and D is a rare earth element from the same list as above. Preferably, y = 0.

Preferably, the first magnetic electrode layer comprises a metallic antiperovskite nitride material of the form Mn₄₋ₓAₓN_{1-y}, and wherein the second magnetic electrode layer comprises a metallic antiperovskite nitride material of the form Mn_{4-x'}A'_{x'}N_{1-y'}, where A and A' are an element selected from a group comprising: Ag, Al, Au, Co, Cu, Fe, Ga, Ge, In, Ir, Ni, Pd, Pt, Rh, Sb, Si, Sn, Zn, and where 0 ≤ x,x' ≤ 1, and 0 ≤ y,y' < 1. Preferably, 0 ≤ x,x' ≤ 0.05, and/or 0 ≤ y,y' ≤ 0.2. Preferably, A and A' are the same element.

In a preferred embodiment, the first magnetic electrode layer and second magnetic electrode layer are formed of or comprise Mn₄N.

Preferably, the first magnetic electrode layer and second magnetic electrode layer are terminated at the interface with the barrier layer by a Mn-Mn-N layer.

Preferably, the first magnetic electrode layer and/or second magnetic electrode layer are strained to induce a collinear ferrimagnetic structure therein. The device may further comprise a strain inducing layer for inducing a strain (compressive or tensile) in at least one of the first magnetic electrode layer and second magnetic electrode layer to thereby induce the collinear ferrimagnetic structure. The strain inducing layer may be or comprise a conductive material and/or a substrate.

The first magnetic electrode layer and second magnetic electrode layer may have a thickness of 100 nm or less, or 50 nm or less, or preferably 20 nm or less or 10 nm or less. The first magnetic electrode layer and second magnetic electrode layer may have a thickness in the range 50 nm to 10 nm. The barrier layer may have a thickness of 20 nm or less, preferably 5 nm or less.

Any device feature as described herein may also be provided as a method feature, and vice versa. As used herein, means plus function features may be expressed alternatively in terms of their corresponding structure. Any, some and/or all features in one aspect of the invention may be applied to other aspects of the invention, in any appropriate combination or sub-combination. In particular, device aspects may be applied to method aspects, and vice versa.

It should also be appreciated that particular combinations of the various features described and defined in any aspect of the invention can be implemented and/or supplied and/or used independently. The invention extends to methods, systems and devices substantially as herein described and/or as illustrated with reference to the accompanying figures. The invention also extends to any novel aspects or features described and/or illustrated herein.

In this specification the word 'or' can be interpreted in the exclusive or inclusive sense unless stated otherwise. Whilst the invention has been described in the context of memory, it can also be implemented in any field of use where a magnetic device with switchable resistance states is required, either on an individual scale or in a large-scale array of devices.

### Brief Description of Drawings

In order that the invention can be well understood, embodiments will now be discussed by way of example only with reference to the accompanying drawings, in which:
**Figure 1** is a schematic diagram of a magnetic device according to an embodiment of the present invention;
**Figure 2** shows an example cubic antiperovskite structure in the case of Cu₃PdN;
**Figure 3** shows an example cubic antiperovskite structure in the case of Mn₃GaN;
**Figure 4** is a schematic diagram of a magnetic device according to an embodiment including a strain inducing layer;
**Figure 5(a)** shows a schematic diagram of a magnetic device according to an embodiment of the present invention;
**Figure 5(b)** shows the simulated transmission of the magnetic device structure of figure 5(a) for the parallel (P) and antiparallel (AP) net magnetisation states as a function of energy;
**Figure 5(c)** shows the simulated magnetoresistance of the magnetic device of figure 5(a) as a function of energy;
**Figure 6(a)** shows a schematic diagram of a magnetic device according to another embodiment of the present invention;
**Figure 6(b)** shows the simulated density of states of the magnetic device structure of figure 6(a) as a function of energy;
**Figur 6(c)** shows the simulated magnetoresistance of the magnetic device of figure 6(a) as a function of energy;
**Figure 7(a)** shows a schematic diagram of a magnetic device according to another embodiment of the present invention;
**Figure 7(b)** shows the simulated magnetoresistance of the magnetic device of figure 7(a) as a function of energy;
**Figure 8(a)** shows a schematic diagram of a magnetic device according to another embodiment of the present invention;
**Figure 8(b)** shows the simulated density of states of the magnetic device structure of figure 8(a) as a function of energy;
**Figure 8(c)** shows the simulated transmission of the magnetic device structure of figure 8(a) for the parallel (P) and antiparallel (AP) net magnetisation states;
**Figure 8(d)** shows the simulated magnetoresistance of the magnetic device of figure 8(a);
**Figure 9(a)** shows a schematic diagram of a magnetic device according to another embodiment of the present invention; and
**Figure 9(b)** shows the simulated magnetoresistance of the magnetic device of figure 9(a).

It should be noted that the figures are diagrammatic and may not be drawn to scale. Relative dimensions and proportions of parts of these figures may have been shown exaggerated or reduced in size, for the sake of clarity and convenience in the drawings. The same reference signs are generally used to refer to corresponding or similar features in modified and/or different embodiments.

### Detailed Description

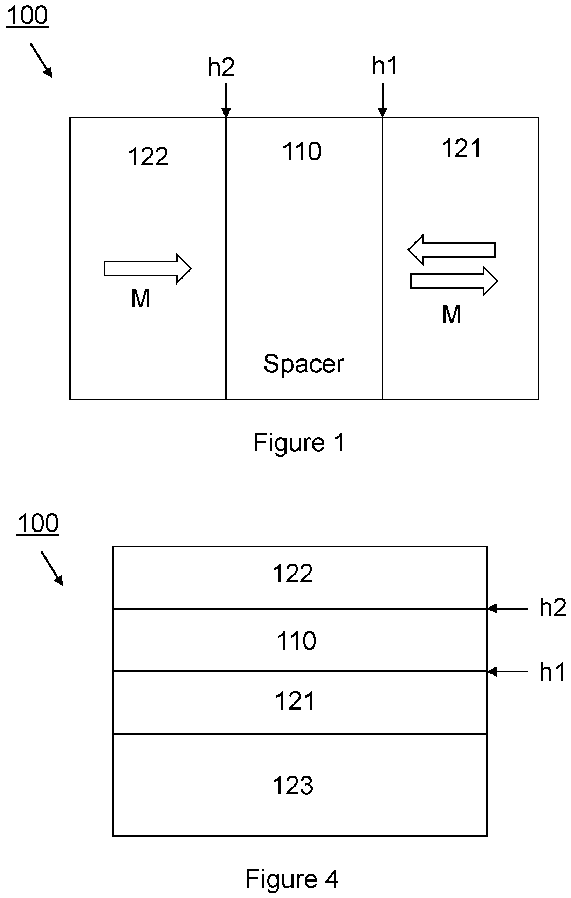

Figure 1 shows schematic diagram of a magnetic device 100 according to the present invention. The device 100 comprises a spacer layer 110, a first magnetic electrode layer 121 on one side of the spacer layer 110, and a second magnetic electrode layer 122 on the other (opposite) side of the spacer layer 110. The relative (net) magnetisation orientation of the first magnetic electrode layer 121 and second magnetic electrode layers 122 is switchable between a parallel (P) and antiparallel (AP) state to thereby control a spin-polarised current through the magnetic device 100. Generally, the spacer layer 110 can be a conductive spacer or a tunnel barrier depending on the material used, as is discussed in more detail below.

The magnetic device 100 is based on an active tri-layer that operates as a magnetic tunnel junction (MJT) when the spacer layer 110 is a tunnel barrier (e.g. insulating) or a spin valve when the spacer layer 110 is conductive. Specifically, one of the electrode layers (the first magnetic electrode layer 121 in the figure 1) is configured (through its dimensions) as a "free" layer whose net magnetisation M can be switched between two directions (indicated by the arrows M in figure 1) and the other electrode layer (the second magnetic electrode layer 122 in the figure 1) is configured as a "pinned" layer whose net magnetisation M direction is fixed. Typically, the free layer 121 is thinner than the pinned layer. The spacer layer 110 helps to avoid exchange bias between the two electrode layers 121, 122 such that the switching of net magnetisation M in one electrode layer does not affect the net magnetisation M in the other electrode layer. In practice, this means the thickness of the spacer layer 110 should be at least a few nm but less than the spin-diffusion length. Where the device 100 is configured as spin valve, the conductive spacer layer 110 is non-magnetic, but for the MTJ configuration the insulating barrier layer 110 can be magnetic or non-magnetic.

The magnetic device 100 exhibits two distinct resistance states, R_{P} (low resistance, ON) and R_{AP} (high resistance, OFF), corresponding to when the net magnetisation M directions in the electrode layers 121, 122 are parallel and antiparallel, respectively. This gives rise to a magnetoresistance (MR) or ON/OFF ratio, referred to as giant magnetoresistance (GMR) in the spin valve configuration and tunnelling magnetoresistance (TMR) in the MTJ configuration. The net magnetisation M direction of the free layer (electrode layer 121 in figure 1) and the resistance state of the magnetic device 100 can be switched by spin-transfer-torque (STT) writing which involves passing a sufficiently high current between the two magnetic electrodes 121, 122, as is known in the art. The MR ratio, combined with the fact that the magnetic electrodes layers 121, 122 can retain their relative net magnetisation direction M for long periods of time makes the magnetic device 100 an attractive candidate for non-volatile memory whereby information is stored/encoded in the parallel and antiparallel state of the first magnetic electrode layer 121 and second magnetic electrode layer 122 and can be read via the different resistances in the ON/OFF states.

The present invention makes use of a novel combination of magnetic and non-magnetic perovskite and antiperovskite materials for the active tri-layer, whose electronic and magnetic properties can be readily tuned through their composition and which can be grown in ultrathin films with high crystalline quality using conventional deposition techniques such as atomic layer deposition (ALD) and physical vapour deposition (PVD).

Specifically, the spacer layer 110 is formed of or comprises a perovskite-like nitride material or a perovskite oxynitride material, and the first magnetic electrode layer 121 and second magnetic electrode layer 122 comprise a metallic antiperovskite nitride material having a ferrimagnetic or antiferromagnetic structure (in the ground, unstrained state). All three layers 110, 121, 122 share the same antiperovskite/perovskite lattice structure (space group 221 in the case of ideal cubic structure, or space group 123 if strained) and all three layers 110, 121, 122 are nitrides or contain at least some nitrogen (such nitride materials can be conductive or insulating). As described in more detail below, the all-perovskite all-nitride structure of the magnetic device 100 supports a number of unique properties that are advantageous for achieving high MR and addressing the challenges with current state-of-the-art MRAM technologies including scalability, endurance, dynamic range, thermal stability and power consumption.

Antiperovskites are a family of alloys with a crystal structure identical to the well-known perovskite structure (which is cubic in the absence of strain) but with the positions of anion and cation constituent elements reversed in the unit cell. Antiperovskites can thus be referred to as "perovskite-like" in the sense that they have the same crystal structure as perovskites. The antiperovskite structure is typically represented by the composition formula M₃BA, where M is a cation occupying the face-centre sites of the unit cell, B is an anion that occupies the corner sites of the unit cell, and A is an anion that occupies the body-centre site of the unit cell. Where the centre site element A is nitrogen (N), as in the present invention, the structure is an antiperovskite nitride.

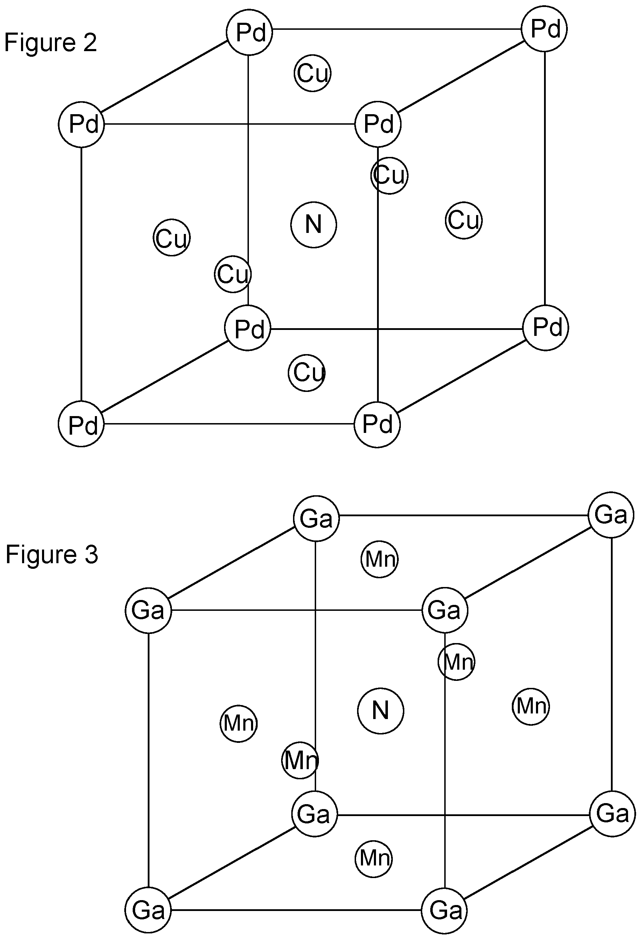

Figure 2 illustrates the ideal cubic unit cell (in the absence of strain) of a Cu-based metallic antiperovskite nitride Cu₃PdN, which is used in some embodiments as a conductive spacer layer 110. Figure 3 illustrates the ideal cubic unit cell (in the absence of strain) of a Mn-based metallic antiperovskite nitride Mn₃GaN, which is used in some embodiments for the magnetic electrode layers 121, 122.

Due to the identical crystal structure and similar lattice parameters of the perovskite/antiperovskite layers, the all-perovskite active tri-layer of the magnetic device 100 can be produced with minimal lattice mismatch and high quality heterointerfaces h1, 12 which contribute to high robustness and endurance of the magnetic device 100. Further, as discussed below, the specific combination of materials of the spacer layer 110 and electrode layers 121, 122, together with their interfaces can produce large GMR and TMR.

A particular advantage of the all-perovskite all-nitride all structure of the magnetic device 100 is the high spin polarisation of electronic states at the Fermi energy (where electrical transport predominantly takes place) in the electrode layers 121, 122 at the interfaces h1, h2 with the spacer layer 110, and the efficient k-filtering provided by the spacer layer 110. The ferrimagnetic or antiferromagnetic electrodes 121, 122 provide highly spin polarised conduction channels in the bulk, but the challenge is maintaining a high spin polarisation across the interfaces h1, h2 with the spacer layer 110 in order to achieve high MR. The all-nitride nature of the tri-layer provides a less abrupt change in the lattice constituents at the interfaces h1, h2. The resulting low lattice disorder at the interfaces h1, h2 ensures low scattering and high spin coherence which contributes to maintaining a high spin polarization across the interfaces h1, h2. This, combined with efficient k-filtering in the spacer layer 110, can provide high GMR or TMR.

In addition, the position of the Fermi level in the magnetic device 100 (and the conductivity of the spacer layer 110) is controllable by the composition of each layer 110, 121, 122. Because the spin polarization of the electronic states at Fermi energy in the ferrimagnetic or antiferromagnetic electrode layers 121, 122 is momentum-dependent (k-dependent), the TMR or GMR in the magnetic device 100 can be maximised by tuning chemical composition without changing the lattice structure or magnetic structure.

In an embodiment of the magnetic device 100, the first magnetic electrode layer 121 is formed of or comprises a metallic antiperovskite nitride material of the form Mn₄₋ₓAₓN_{1-y}, and the second magnetic electrode layer 122 is formed of or comprises a metallic antiperovskite nitride material of the form Mn_{4-x'}A'_{x'}N_{1-y'}, where A and A' are a corner site element selected from a group comprising: Ag, Al, Au, Co, Cu, Fe, Ga, Ge, In, Ir, Ni, Pd, Pt, Rh, Sb, Si, Sn, Zn. Composition parameters x,x' can vary in the range 0 ≤ x,x' ≤ 1, and y,y' can vary in the range 0 ≤ y,y' < 1. The compositional parameters indicate the occupancy of the element in the antiperovskite lattice, which refers to the proportion or fraction of respective lattice sites, averaged over the layer, that are occupied by the element. The first magnetic electrode layer 121 and second magnetic electrode layer 122 have a thickness of 50 nm or less, and preferably 20 nm or less or 10 nm or less. The same electrode materials can be used for the spin valve configuration of the magnetic device 100 where the spacer layer 110 is conductive, or for the MTJ configuration of the magnetic device 100 where the spacer layer 110 is a tunnel barrier, as described further below.

The alloy Mn₄₋ₓAₓN_{1-y} is a family of magnetic antiperovskite nitrides with a predominantly ferrimagnetic structure, highly spin polarised conduction channels, high Curie/Neel temperature, and high magnetic anisotropy. Advantageously, the position of the Fermi energy and conductivity of the Mn₄₋ₓAₓN_{1-y} electrode layers 121, 122 can be tuned through the composition (i.e., through A, A'; x,x'; y, y').

The magnetic structure and properties of the Mn₄₋ₓAₓN_{1-y} family can vary with the composition (x,x'). For example, the metallic antiperivskite nitride Mn₄N (x = 0) is a non-collinear ferrimagnet in the bulk cubic form, while some compounds in the Mn₄₋ₓAₓN_{1-y} family, such as Mn₃GaN (x=1), can have a fully compensated (non-collinear) triangular antiferromagnetic structure in the bulk cubic form, but a nonlinear canted antiferromagnetic structure with non-zero net magnetisation under strain (by way of example only, strain due to lattice mismatch with a substrate typically becomes relaxed for a layer thickness of 100 nm or more at which point the material can be considered to be in its bulk form). In addition, small substitutions of Mn with element A, A' (e.g. 0 ≤ x,x' ≤ 0.05) can tune the position of the Fermi energy and conductivity without significantly changing the electronic or magnetic structure. Accordingly, in some embodiments, small substitutions of Mn (e.g. 0 < x,x' ≤ 0.05) with element A,A' (e.g. Ga) are used to tune the spin polarisation of electronic states at the Fermi energy at the interface with the spacer layer 110, and tune the change of interfacial density of states with net magnetisation direction M, both of which contribute to the MR. Starting from Mn₄N, introducing small occupancies of A,A' can also reduce the net magnetization (or even reach full compensation of the ferrimagnetic state, i.e. zero magnetization).

Preferably, elements A and A' are the same so that the magnetic properties of the first and second electrodes 121, 122 are similar. In specific examples, the first and second electrode layers 121, 122 are formed of or comprise Mn₄N or Mn₃GaN.

Preferably, the first magnetic electrode layer 121 and second magnetic electrode layer 122 are terminated at the interface with the spacer layer 110 by a Mn-Mn-N layer. According to density functional theory (DFT) simulations (see below), the spin polarisation of this termination layer (as opposed to the Mn-Mn or Mn-A layers) is only slightly compromised by contact with the spacer layer 110 and thus allows a high spin polarisation of charge carriers to be maintained at the interfaces h1, h2. However, it will be appreciated that in practice the interfaces h1, h2 may not be atomically flat and/or may include areas of different atomic compositions at the interface h1, h2. This may lower the observed MR, but a high MR will still be obtained even if an ideal interfacial composition is not achieved across the whole interface area. Control over the interface termination can be achieved using known deposition techniques such as ALD and/or PVD, as described in more detail below.

The magnetic device 100 may further includes a substrate layer 123 adjacent to one of the electrode layers 121, 122, as shown in figure 4. In the illustrated example, the substrate layer 123 is adjacent the first magnetic electrode layer 121, although it will be appreciated that it may instead be adjacent the second magnetic electrode layer 122. A lattice mismatch between the substrate layer 123 and the adjacent electrode layer 121, 122 will induce a strain in the electrode layers 121, 122. Specifically, because the electrode layers 121, 122 and spacer layer 110 are sufficiently thin, this strain will be transferred through the spacer layer 110 to the other electrode layer 121, 122.

In an embodiment, the substrate layer 123 has a different lattice parameter or structure to the electrode layers 121, 122 to induce a strain in the electrode layers 121, 122. In this case, the substrate 123 can be referred to as a strain-inducing layer 123. The strain inducing layer 123 is used to induce a collinear ferrimagnetic structure in the electrode layers 121, 122. Advantageously, this magnetic structure exhibits a higher Curie temperature (e.g. T_{c} ~ 700 K), and higher magnetic anisotropy (PMA ~ 0.1 MJ/m³) than the ground/unstrained state, while keeping saturation magnetization low (Mₛ ~ 100 kA/m) due to mutual compensation of the magnetic moments on the Mn atoms. For example, while Mn₄N has a non-collinear ferrimagnetic ground state it transforms to have a collinear ferrimagnetic structure under strain. Preferably, the strain is a (in plane) tensile or compressive strain. DTF simulations indicate that strain of up to 1% or 2% does not compromise the MR ratio significantly.

In one example, to achieve a collinear ferrimagnetic state in Mn₄N a tensile strain of up to 1 or up to 2% is needed (or c/a ratio ≤ 0.99, where the c/a ratio refers to the ratio of the height (c) to the side (a or b) of the unit cell). A suitable strain can be achieved by deposition of Mn₄N on a substrate layer 123 of SrTiO₃ or MgO. Other suitable materials for the substrate layer 123 / the strain inducing layer include: BaₓSr₁₋ₓTiO₃ (0 ≤ x ≤ 1), BaZrₓTi₁₋ₓO₃ (0 ≤ x ≤ 1), PbZrₓTi₁₋ₓO₃ (0 ≤ x ≤ 1), SrRuO₃, Nb:SrTiO₃, LaAlO₃, (LaAlO₃)₃(Sr₂AlTaO₆)₇ (known as LSAT), (Pb(Mg_{0.33}Nb_{0.67})O₃)ₓ - (PbTiO₃)₁₋ₓ (known as PMN-PT, where 0.28 ≤ x ≤ 0.32), SrMoO₃, Cu₃PdN, Pt, Au, Pd or Si. The magnetic state/structure of the electrode layers 121, 122 can be determined experimentally using standard magnetometry techniques, as is known in the art.

The ground state of Mn₃GaN is a fully compensated triangular antiferromagnetic state with zero net magnetisation, but in most practical cases where some strain is induced by a substrate or adjacent layers this transforms into a non-collinear (canted) antiferromagnetic structure with a small net magnetisation. Finite-temperature DFT simulations performed by the inventors predict that tensile (or compressive) strains of up to 1% or 2% in Mn₃GaN can also lead to a collinear ferrimagnetic state at elevated temperatures at or above 300 Kelvin (see J. Zemen et al. "Frustrated magnetism and caloric effects in Mn-based antiperovskite nitrides: Ab initio theory" Physical Review B, 95, 184438 (2017)).

Additionally or alternatively, introducing a nitrogen deficiency, i.e. y > 0, in the spacer layer 110 can be used to tune the lattice (mis)matching between the electrode layers 121, 122 and the substrate layer 123 (and to control the Curie/Neel temperature of the antiperovskite nitride), without changing the magnetic structure or lattice structure. Thus, aside from the choice of substrate material, a small nitrogen deficiency can be used to induce a strain in the electrode layers 121, 122. The nitrogen deficiency thus provides an extra degree of freedom for engineering strain in the magnetic device 100. Preferably the nitrogen deficiency is kept relatively low, 0 ≤ y,y' ≤ 0.2, to avoid changing the bulk magnetic structure or lattice structure.

In embodiments where the magnetic device 100 operates as a spin valve, the spacer layer 110 is preferably formed of or comprises a conductive antiperovskite nitride material of the form Cu₃D_{z}N_{1-y}, where D is a corner site element selected from a group comprising: Pd, Rh, Ru, Cu, Ag, Al, Au, Co, Cu, Fe, Ga, Ge, In, Ir, Mn, Ni, Pt, Sb, Si, Sn, and Zn, and the composition parameters z and y can vary in the range 0 ≤ z ≤ 1, 0 ≤ y < 1. The spacer layer 110 has a thickness of 20 nm or less, and preferably 5 nm or less. The thickness of the conductive spacer layer 110 in the spin valve configuration can be thicker than the insulating barrier layer in the MTJ configuration, as resistance is less of an issue.

Cu₃D_{z}N_{1-y} is a thermodynamically stable non-magnetic metallic antiperovskite nitride with excellent k-filtering properties, suitable for achieving high MR. The band structure and conductance of Cu₃D_{z}N_{1-y} can be varied through the occupancy (z) of corner site elements D during deposition to tune the MR. Cu₃N (i.e. z = 0) in bulk form (e.g. over 20 nm thick) is a semiconductor with a small indirect band gap and excellent k-filtering properties suitable for producing high MR. In thin film form (e.g. 20 nm or less), as in the embodiments, DFT simulations indicate the energy band gap closes and Cu₃N is metallic, but the k-filtering properties remain high and is advantageous for producing high GMR. Its conductivity can be further increased by introducing transition metal atoms (D = Pd, Rh or Ru) at the corner site (z > 0).

Preferably, the spacer layer 110 is terminated at the interface h1, h2 with the first and second electrode layers 121, 122 by a Cu-D layer. This termination layer is advantageous for maintaining high spin polarisation of charge carriers at the interface with the electrodes and thus high MR. However, similar to the termination of the electrode layers 121, 122, while this is the ideal termination, the interfacial composition may in practice include areas with different atomic compositions.

In specific examples, the spacer layer 110 is formed of or comprises Cu₃N or Cu₃PdN.

In an alternative embodiment, the spacer layer 110 is formed of or comprises a conductive perovskite nitride material of the form DReN₃, where D is a rare earth element selected from a group comprising: La, Ce, Pr, Nd, Pm, Sm, Eu, Gd, Tb, Dy, Ho, Er, Tm, Yb and Lu. The compound family DReN_{3-y} is another perovskite nitride which includes metallic and semiconducting materials and which also have good k-filtering properties suitable for achieving high MR. In such examples, a nitrogen deficiency can be produced dependent on the deposition conditions, such that the spacer layer 110 can be of the form DReN_{3-y}, where 0 ≤ y ≤ 1 and D is a rare earth element from the same list as above.

In embodiments where the magnetic device 100 operates as an MTJ, the spacer layer 110 is a tunnel barrier formed of or comprising an insulating/non-conductive perovskite nitride or an insulating/nonconductive oxynitride material. An oxynitride comprises oxygen and nitrogen in some proportion or composition. An oxynitride may be a nitrogen-substituted perovskite oxide material or a nitrogen-substituted oxide material (i.e. wherein the substitution element typically has a relatively small occupancy compared to the element it is substituting).

In the MTJ configuration, the barrier layer 110 has a thickness of at least 1 nm and 10 nm or less, preferably 3 nm or less. In practice, there is a balance between the barrier layer 110 being thick enough to remove exchange bias between the electrode layers 121, 122 and ensure tunnelling transport but not too thick so as to overly limit the tunnel current through the magnetic device 100 which is detrimental to switching the magnetization (writing) and measuring the resistance (reading). These conditions are met within the above range.

In a preferred embodiment of the MTJ configuration, the spacer layer 110 is formed of or comprises a (insulating) perovskite oxynitride material of the form SrTiO_{3-z}N_{z} or DFeO_{3-z}N_{z}, where D is a rare earth element selected from a group comprising: La, Ce, Pr, Nd, Pm, Sm, Eu, Gd, Tb, Dy, Ho, Er, Tm, Yb and Lu, and where 0 ≤ z ≤ 3. Preferably, 0 ≤ z ≤ 1.

Aside from improving the spin polarisation at the interfaces with the electrode layers 121, 122, as discussed above, the introduction of nitrogen in the perovskite oxide material can advantageously be used to control the band gap, k-filtering and transport properties of the spacer layer 110 to tune the MR. It also reduces the amount of oxygen in the spacer layer 110 which reduces the amount of oxygen diffusion into the electrode layers 121, 122. Oxygen diffusion into the electrode layers of current state-of-the-art MTJ devices is a major problem which overtime can corrode the metallic electrodes while at the same time leads to the formation and propagation of oxygen vacancies in the barrier layer, which degrades the device performance. In the case of the all-perovskite all-nitride structure of the present invention, the lattice structure of the electrode layers 121, 122 is the same as the spacer layer 110 and the oxygen concentration gradient at the interfaces h1, h2 is reduced, making the active tri-layer more stable with respect to diffusion of small atoms like oxygen across the interface. Reducing oxygen diffusion in accordance with the present invention will therefore extend the lifetime and endurance of the magnetic device 100 which is particularly advantages for memory applications.

In an example, the spacer layer 110 is formed of or comprises SrTiO₃ or DFeO₃, where D is a rare earth element selected from a group comprising: La, Ce, Pr, Nd, Pm, Sm, Eu, Gd, Tb, Dy, Ho, Er, Tm, Yb and Lu. In such examples, an oxygen deficiency can be produced dependent on the deposition conditions, such that the spacer layer 110 can be of the form SrTiO_{3-y} or DFeO_{3-y}, where 0 ≤ y ≤ 1 and D is a rare earth element from the same list as above.

In an alternative embodiment, the spacer layer 110 is formed of or comprises a (insulating) perovskite nitride material of the form DWN₃, where D is a rare earth element selected from a group comprising: La, Ce, Pr, Nd, Pm, Sm, Eu, Gd, Tb, Dy, Ho, Er, Tm, Yb and Lu. Preferably, the element D is La. In addition to assisting in preserving spin polarisation, this material contains no oxygen thus supressing electrode oxidation. Similarly, in such embodiments, a nitrogen deficiency can be produced dependent on the deposition conditions, such that the spacer layer 110 can be of the form DWN_{3-y}, where 0 ≤ y ≤ 1 and D is a rare earth element from the same list as above.

To illustrate the effects of specific embodiments of the invention, simulations were performed of certain exemplary magnetic device heterostructures. Simulations were performed using atomic-scale modeling tools from the QuantumATK package developed by Synopsys, in particular, DFT simulations with localized basis sets (LCAO - linear combination of atomic orbitals) were performed using the LDA exchange correlation potential and FHI-DZP basis set for calculation of the electronic structure. Transport properties were calculated using the formalism of non-equilibrium Green's functions (NEGF). These simulation techniques are described e.g. by D. Zhipeng et al. in "Tunneling current in HfO2 and Hf05Zr05O2 based ferroelectric tunnel junction", Journal of Applied Physics, Vol. 123, pp. 094501-094501 (2018), and by N. Branislav et al. in "First-principles quantum transport modeling of spin-transfer and spin-orbit torques in magnetic multilayers." Handbook of Materials Modeling: Applications: Current and Emerging Materials (2020): 499-533. The simulation results are limited to zero temperature.

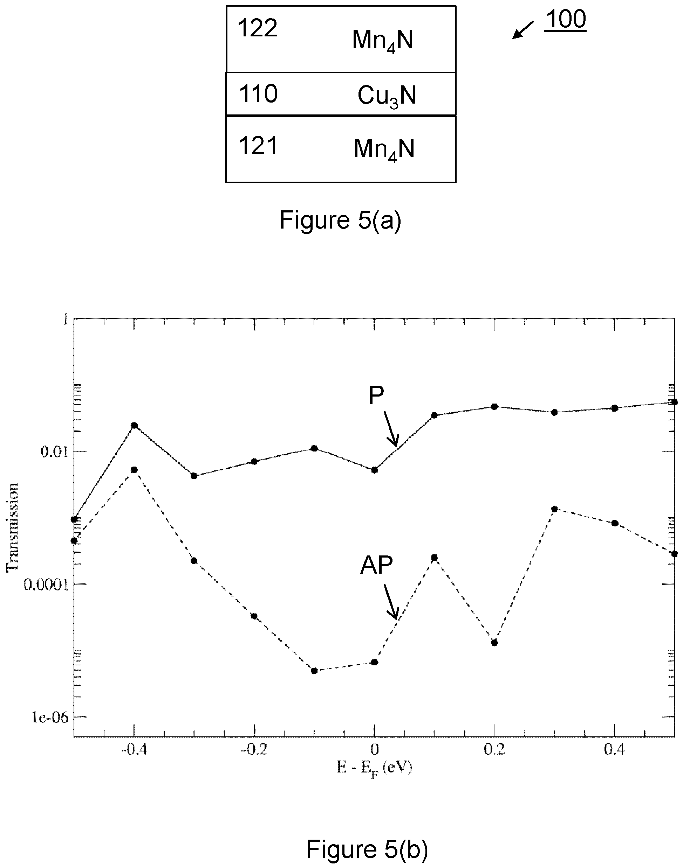

Figure 5(a) shows a schematic diagram of a first example magnetic device 100 structure which is simulated. The magnetic device 100 is a spin valve having a 2nm thick spacer layer 110 of Cu₃N sandwiched between electrode layers 121, 122 of Mn₄N. The Cu₃N spacer layer 110 was terminated by a Cu layer at the interfaces h1, h2, and the Mn₄N electrode layers 121, 122 were terminated by Mn-Mn-N at the interfaces h1, h2. An in plane tensile strain of approximately 1.7% in the Mn₄N electrode layers 121, 122 was included to simulate the effect of a substrate layer 123 and induce a collinear ferrimagnetic structure in the Mn₄N electrode layers 121, 122.

Figure 5(b) shows the simulated transmission through the magnetic device 100 as a function of energy for the parallel (P) and antiparallel (AP) (net) magnetisation states of the magnetic device 100. It can be seen that there is a significant difference in the transmission at and near the Fermi energy (E-E_{F}=0) where electronic transport takes place, which is indicative of a large GMR of the magnetic device 100.

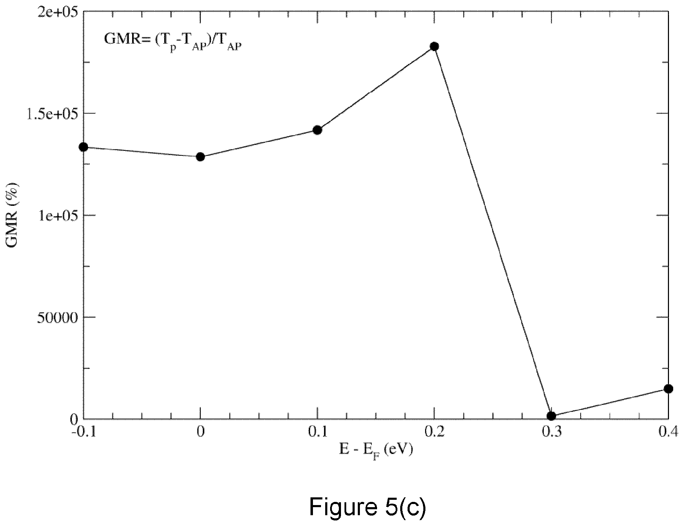

Figure 5(c) shows the resulting GMR as a function of energy, which is calculated as GMR = (T_{P}-T_{AP})/T_{AP}. The calculated GMR at the Fermi energy (E-E_{F} = 0) is approximately 1.4x10⁵ %. This is extremely high whereby, in the prior art, anything over 100% is considered high. Indeed, this value of MR would be high even for an MTJ device. This is a simulation of an idealised structure at zero temperature and it may thus be an overestimation of the MR. In practice, the experimental MR value may be lower due to a combination of different terminations of the electrode layers 121, 122 at the interfaces h1, h2 and non-ideal crystallinity of all the layers 110, 121, 122. However, the simulation demonstrates the advantageous properties of the all-perovskite all-nitride magnetic device 100 of the invention.

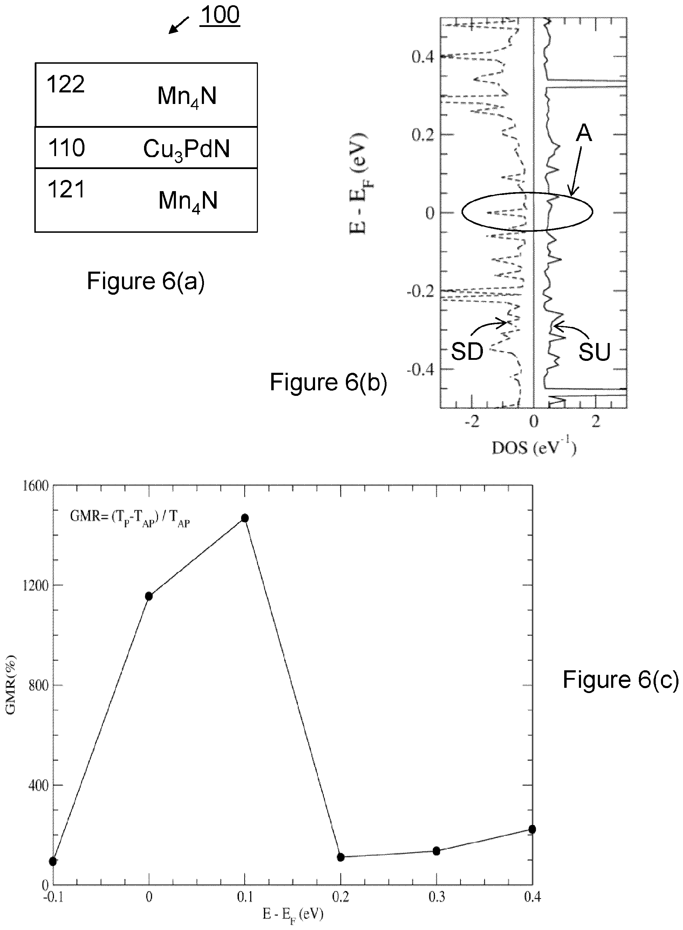

Figure 6(a) shows a second example magnetic device 100 structure which is simulated. The magnetic device 100 is again a spin valve, this time having a 2nm thick spacer layer 110 of Cu₃PdN sandwiched between electrode layers 121, 122 of Mn₄N. The Cu₃PdN spacer layer 110 was terminated by a Cu-Pd layer at the interfaces h1, h1, and the Mn₄N electrode layers 121, 122 were again terminated by Mn-Mn-N at the interfaces h1, h2. An in plane tensile strain of approximately 1.7% in the Mn₄N electrode layers 121, 122 was included to simulate the effect of a substrate layer 123 and induce a collinear ferrimagnetic structure in the Mn₄N electrode layers 121, 122.

Figure 6(b) shows the projected density of states (DOS) for spin up (SU) and spin down (SD) electrons of the Mn-Mn-N layer of the electrode layer 121 in contact with the Cu₃PdN layer 110 as a function of energy. It can be seen from the region labelled A, that there is a significant difference in the DOS for the two spin populations at and near the Fermi energy (E-E_{F}=0) where electronic transport takes place, which is indicative of a high spin polarisation of the magnetic device 100.

Figure 6(c) shows the calculated GMR as a function of energy, which is again calculated from the simulated transmissions as GMR = (T_{P}-T_{AP})/T_{AP}. The calculated GMR at the Fermi energy (E-E_{F} = 0) is approximately 1200 %. This value is somewhat reduced from the calculated GMR with a Cu₃N spacer layer 110, but is still significant in relation to the prior art and is again comparable to TMR values in typical MTJs.

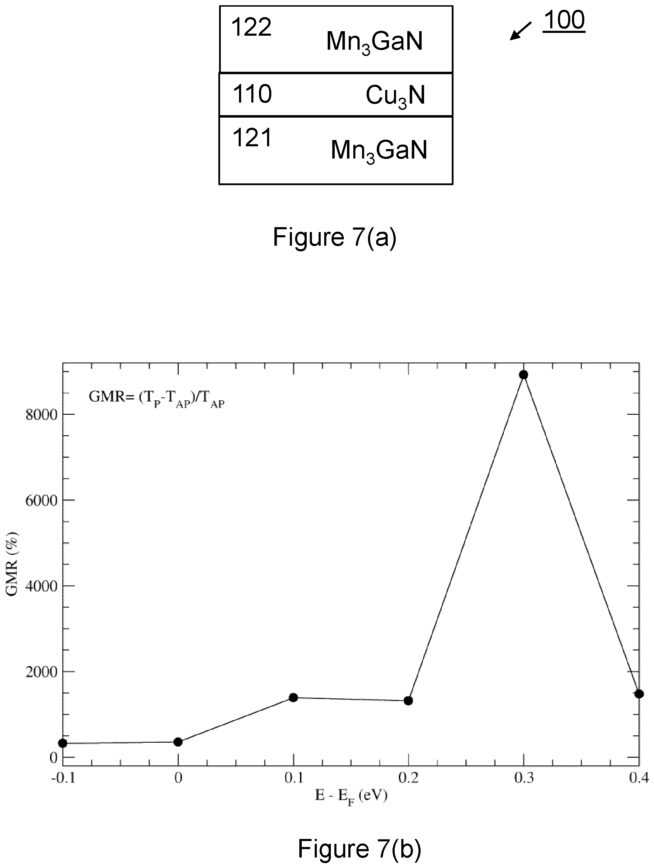

Figure 7(a) shows a third example magnetic device 100 structure which is simulated, again as a spin valve. The magnetic device 100 has a 2nm thick spacer layer 110 of Cu₃N sandwiched between electrode layers 121, 122 of Mn₃GaN. The Cu₃N spacer layer 110 was terminated by a Cu layer at the interfaces h1, h1, and the Mn₃GaN electrode layers 121, 122 were terminated by Mn-Mn-N at the interfaces h1, h2. An in-plane tensile strain of approximately 1.6% was produced in the Mn₃GaN electrode layers 121, 122 due to lattice mismatch with the spacer layer 110, inducing a non-collinear (canted) antiferromagnetic state with a small net magnetization in the Mn₃GaN electrode layers 121, 122.

Figure 7(b) shows the calculated GMR as a function of energy calculated from the simulated transmissions as GMR = (T_{P}-T_{AP})/T_{AP}. The calculated GMR at the Fermi energy (E-E_{F} = 0) is approximately 300 %. This value is somewhat lower than the calculated GMR in the Mn₄N/Cu₃N/Mn₄N and Mn₄N/Cu₃PdN/Mn₄N structures demonstrating the advantages of utilising the collinear ferrimagnetic structure of Mn₄N (stabilised by strain) compared to the non-collinear (canted) antiferromagnetic structure of Mn₃GaN.

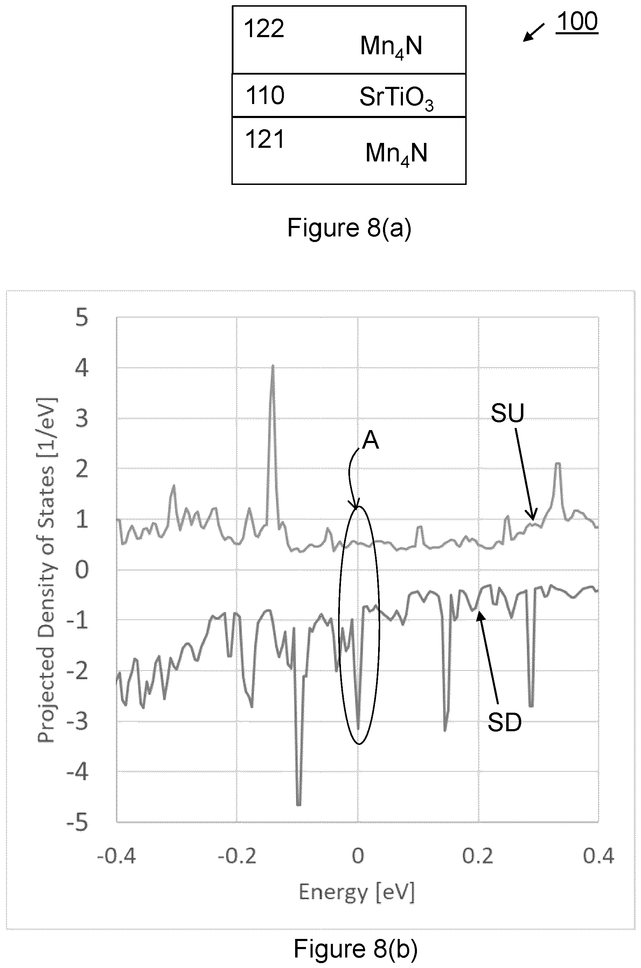

Figure 8(a) shows a fourth example magnetic device 100 structure which is simulated, this time as an MTJ. The magnetic device 100 has a 2nm thick spacer layer 110 of SrTiO₃ sandwiched between electrode layers 121, 122 of Mn₄N. The SrTiO₃ spacer layer 110 was terminated by a Ti-O-O layer at the interfaces h1, h2, and the Mn₄N electrode layers 121, 122 were terminated by Mn-Mn-N at the interfaces h1, h2.

Figure 8(b) shows the projected DOS for spin up (SU) and spin down (SD) electrons of the Mn-Mn-N layer of the electrode layer 121 (or electrode 122) in contact with the SrTiO₃ layer 110 as a function of energy. It can be seen from the region labelled B, that there is a significant difference in the DOS for the two spin populations at and near the Fermi energy (E-E_{F}=0) where electronic transport takes place, which is indicative of a large spin polarisation.

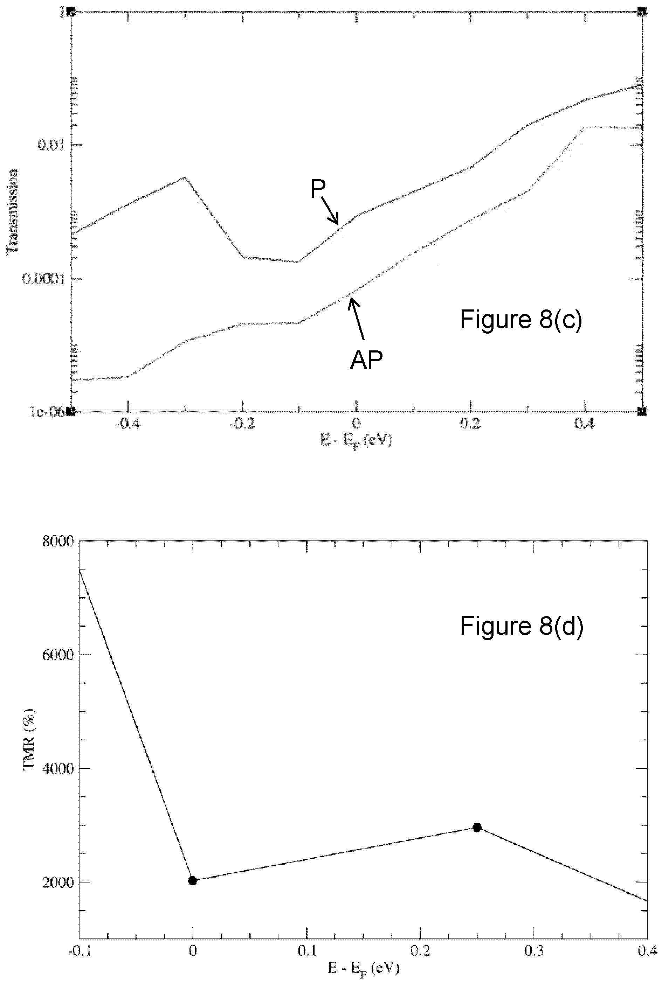

Figure 8(c) shows the simulated transmission T through the magnetic device 100 as a function of energy for the parallel (P) and antiparallel (AP) (net) magnetisation states of the magnetic device 100. Figure 8(d) shows the resulting TMR as a function of energy, which is calculated as TMR = (T_{P}-T_{AP})/T_{AP}. The calculated TMR at the Fermi energy (E-E_{F} = 0) is approximately 2000 % which is high and demonstrates the advantageous properties of the all-perovskite all-nitride magnetic device 100 for MTJs provided in the invention.

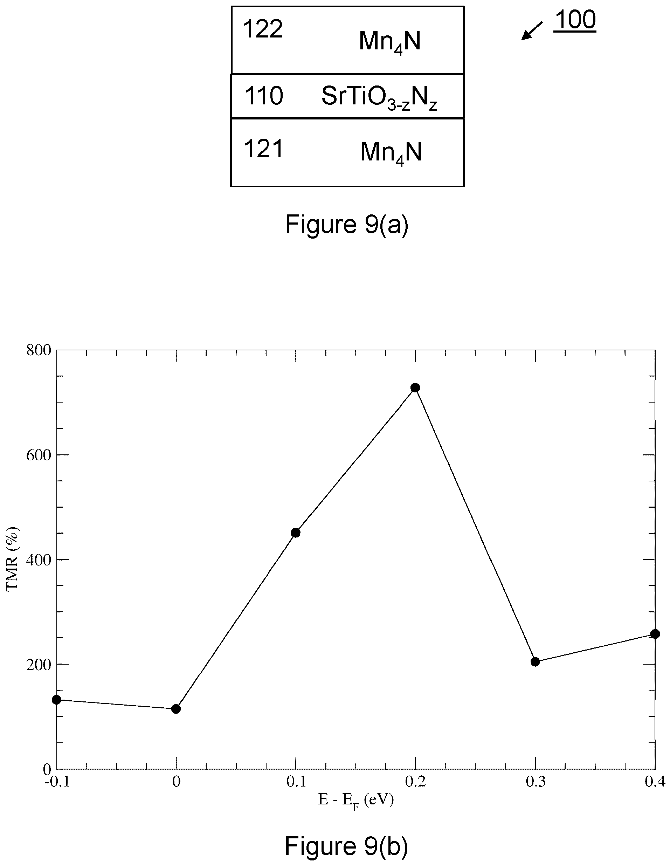

Figure 9(a) shows a fifth example magnetic device 100 structure which is simulated, again as an MTJ. The magnetic device 100 has the same structure as in figure 8(a) but a nitrogen-substituted SrTiO_{3-z}N_{z} barrier layer/space layer 110, where z = 1 and Strontium (Sr) is substituted for nitrogen (whereby the atomic positions of the substituted nitrogen were relaxed in the simulation). Figure 9(b) shows the simulated TMR of magnetic device 100 as a function of energy.

Furthermore, the perovskite and antiperovskite layers of the magnetic device 100 of the embodiments/examples of the present invention can be manufactured using any suitable thin film deposition method, optimised for the required layers and materials. For example, ALD, pulsed laser deposition (PLD), magnetron sputtering (PVD), or a combination of different techniques can be used.

In order to obtain a thin layer with varied composition and occupancy one can employ various methods. For example, the most common approach using PVD is to co-sputter the elements from two targets and control the power on one target while keeping other constant. In the case of Cu₃PdN, the power on the Pd target is controlled/varied. To achieve atomically sharp and well-defined interfaces, it is necessary to control the temperature of the substrate to reduce the mobility of the adatoms so that the desired heterointerface is achieved. In one example, a suitable temperature for deposition of stoichiometric Cu₃PdN is between 100 to 400 °C. The thermal stability of Cu₃N can also be increased by weak doping with Mn (e.g. less than 3% of Mn). In addition, the desired interface for a given material combination can be produced using PVD techniques through an iterative and empirical process of controlling the deposition conditions such as the interface that is presented to adatoms, substrate orientation, substrate temperature, pressure, and power. It will be appreciated that the invention is not limited to the specific deposition method. For example, desired interfaces can also be produced using atomically controlled deposition techniques such as ALD.

By way of reference only, examples of the preparation of various perovskite and antiperovskite materials for the preparation and application of the magnetic devices and memory cells disclosed by the present invention is provided below. Synthesis and engineering of antiperovskite/perovskite heterostructures is described, e.g. by C. Quintela et al. in "Epitaxial antiperovskite/perovskite heterostructures for materials design" Science Advances 6, 30 (2020). An example of the preparation of Mn₄N layers is described, e.g. by K Ito et al. in "Perpendicular magnetic anisotropy in CoxMn4-xN (x=0 and 0.2) epitaxial films and possibly of tetragonal Mn4N phase" AIP Advances 6, 056201 (2016), and by J. Zeman in "Collinear and noncollinear ferrimagnetic phases in Mn4N investigated by magneto-optical Kerr spectroscopy" Journal of Applied Physics 134, 203902 (2023). An example of the preparation of Mn₃GaN layers is described, e.g. by T Hajiri et al. in "Electrical current switching of the non-collinear antiferromagnet Mn3GaN" Applied Physical Letters 115, 05203 (2019). An example of the preparation of Cu₃PdN and Cu₃N layers is described, e.g. by C. X. Quintela et al. in "Epitaxial thin films of Dirac semimetal antiperovskite Cu3PdN" APL Materials 5, 096103 (2017), and by A Jiang et al. in "Preparation, structure, properties and application of copper nitride (Cu3N) thin films: A Review" Journal of Materials Science and Technology 34, 1467 (2018). An example of the preparation of LaWN₃ layers is described, e.g. by K. Talley et al. in "Synthesis of LaWN3 nitride perovskite with polar symmetry" Science 374 6574 (2021) and by K. Hanzawa et al. in "Heteroepitaxial Growth, Degenerate State, and Superconductivity of Perovskite-Type LaWN3 Thin Films" ACS Applied Electronic Materials 5, 2793 (2023). An example of the preparation of LaReN₃ layers is described, e.g. by S. Klob et al. in "Preparation of Bulk-Phase Nitride Perovskite LaReN3 and Topotactic Reduction to LaNiO2-Type LaReN2" Angewandte Chemie 60, 22260 (2021). An example of the synthesis and deposition of LaFeO₃ is described, e.g. by J. W. Seo et al. in "Antiferromagnetic LaFeO3 thin films and their effect on exchange bias" Journal of Physics: Condensed Matter 20, 264014 (2008). An example of the preparation of SrTiO₃ and N-doped SrTiO₃ layers is described, e.g. by M. Vehkamaki et al. in "Growth of SrTiO3 and BaTiO3 Thin Films by Atomic Layer Deposition" Electrochemical and Solid State Letters 2, 504 (1999), and in I Marozau et al. in "One-step preparation of N-doped strontium titanate films by pulsed laser deposition" Applied Physics A 89, 933 (2007).

As described by the simulations of embodiments and exemplary structures herein, the novel magnetic device 100 structure of the invention provides high MR ratio (TMR or GMR) combined with high endurance, high PMA, low saturation magnetization, and high Curie/Neel temperature, which is particularly advantageous for memory applications.

The invention thus provides a novel all-perovskite solution to address the challenges of state-of-the-art STT-MRAM such as: low dynamic range, low thermal stability and high energy consumption due to high switching current densities. Furthermore, the all-nitride all-perovskite structure of the active tri-layer (electrode layers 121, 122; spacer layer 110) ensures high mechanical stability and good lattice match between individual layers. Low lattice disorder at the interfaces h1, h2 between electrodes 121, 122 and the spacer layer 110 ensures low scattering and high spin coherence which contribute to producing large MR. The structure also does not involve any toxic or rare elements, and it is CMOS compatible.

It will be understood that the present invention has been described above purely by way of example, and modifications of detail can be made within the scope of the invention defined in the claims. From reading the present disclosure, other variations and modifications will be apparent to the skilled person. Such variations and modifications may involve equivalent and other features which are already known in the art, and which may be used instead of, or in addition to, features already described herein. Any such modifications or equivalent changes and modifications made to the above embodiments based on the inventive concept of the present invention still fall within the scope of the present invention.

Although the appended claims are directed to particular combinations of features, it should be understood that the scope of the disclosure of the present invention also includes any novel feature or any novel combination of features disclosed herein either explicitly or implicitly or any generalisation thereof, whether or not it relates to the same invention as presently claimed in any claim and whether or not it mitigates any or all of the same technical problems as does the present invention.

Each feature disclosed in the description, and (where appropriate) the claims and drawings may be provided independently or in any appropriate combination. Features which are described in the context of separate embodiments may also be provided in combination in a single embodiment. Conversely, various features which are, for brevity, described in the context of a single embodiment, may also be provided separately or in any suitable sub-combination. Reference numerals appearing in the claims are by way of illustration only and shall have no limiting effect on the scope of the claims.

## Claims

1. A magnetic device, comprising:
a spacer layer;
a first magnetic electrode layer on one side of the spacer layer; and
a second magnetic electrode layer on the other side of the spacer layer;
wherein the spacer layer comprises a perovskite nitride or perovskite oxynitride material,
wherein the first magnetic electrode layer and second magnetic electrode layer comprise a metallic antiperovskite nitride material,
wherein the relative net magnetisation orientation of the first magnetic electrode layer and second magnetic electrode layer is switchable between a parallel and antiparallel net magnetisation state to control a spin-polarised current therethrough.

2. The magnetic device of claim 1, wherein the spacer layer comprises a conductive perovskite nitride material, preferably with a thickness of 20 nm or less.

3. The magnetic device of claim 1 or 2, wherein the spacer layer comprises a conductive perovskite nitride material of the form Cu₃D_{z}N_{1-y}, where 0 ≤ z ≤ 1, 0 ≤ y < 1, and D is a corner site element selected from a group comprising: Pd, Rh, Ru, Cu, Ag, Al, Au, Co, Cu, Fe, Ga, Ge, In, Ir, Mn, Ni, Pt, Sb, Si, Sn, and Zn; and
wherein the spacer layer is terminated at the interface with the first magnetic electrode layer and second magnetic electrode layer by a Cu layer or Cu-D layer.

4. The magnetic device of claim 1, 2 or 3, wherein the spacer layer comprises Cu₃N or Cu₃PdN; and wherein:
when the spacer layer comprises Cu₃N, the spacer layer is terminated at the interface with the first magnetic electrode layer and second magnetic electrode layer by a Cu layer; and
when the spacer layer comprises Cn₃PdN, the spacer layer is terminated at the interface with the first magnetic electrode layer and second magnetic electrode layer by a Cu-Pd layer.

5. The magnetic device of claim 1 or 2, wherein the spacer layer comprises a conductive perovskite nitride material of the form DReN_{3-y}, where 0 ≤ y ≤ 1 and D is a rare earth element selected from a group comprising: La, Ce, Pr, Nd, Pm, Sm, Eu, Gd, Tb, Dy, Ho, Er, Tm, Yb and Lu.

6. The magnetic device of claim 1, wherein the spacer layer comprises an insulating tunnel barrier layer, and preferably has a thickness of 10 nm or less.

7. The magnetic device of claim 6, wherein the barrier layer comprises an insulating perovskite oxynitride material of the form SrTiO_{3-z}N_{z} or DFeO_{3-z}N_{z}, where 0 ≤ z ≤ 3 and D is a rare earth element selected from a group comprising: La, Ce, Pr, Nd, Pm, Sm, Eu, Gd, Tb, Dy, Ho, Er, Tm, Yb and Lu, and preferably where 0 ≤ z ≤ 1.

8. The magnetic device of claim 6, wherein the barrier layer comprises SrTiO_{3-y} or DFeO_{3-y}, where 0 ≤ y ≤ 1 and D is a rare earth element selected from a group comprising: La, Ce, Pr, Nd, Pm, Sm, Eu, Gd, Tb, Dy, Ho, Er, Tm, Yb and Lu.

9. The magnetic device of claim 6, wherein the barrier layer comprises an insulating perovskite nitride material of the form DWN_{3-y}, where 0 ≤ y ≤ 1 and D is a rare earth element selected from a group comprising: La, Ce, Pr, Nd, Pm, Sm, Eu, Gd, Tb, Dy, Ho, Er, Tm, Yb and Lu.

10. The magnetic device of any preceding claim, wherein the first magnetic electrode layer comprises a metallic antiperovskite nitride material of the form Mn₄₋ₓAₓN_{1-y}, and wherein the second magnetic electrode layer comprises a metallic antiperovskite nitride material of the form Mn_{4-x'}A'_{x'}N_{1-y'}, where 0 ≤ x,x' ≤ 1, and 0 ≤ y,y' < 1; and where A and A' are an element selected from a group comprising: Ag, Al, Au, Co, Cu, Fe, Ga, Ge, In, Ir, Ni, Pd, Pt, Rh, Sb, Si, Sn, Zn.

11. The magnetic device of claim 10, wherein:
0 ≤ x,x' ≤ 0.05 and/or 0 ≤ y,y' ≤ 0.2; and/or
A and A' are the same element; and/or
the first magnetic electrode layer and second magnetic electrode layer comprise Mn₄N or Mn₃GaN; and/or
the first magnetic electrode layer and second magnetic electrode layer are terminated at the interface with the spacer layer by a Mn-Mn-N layer.

12. The magnetic device of any preceding claim, wherein the first and/or second magnetic electrode layers are strained to induce a collinear ferrimagnetic structure therein; and, optionally or preferably,
wherein the device further comprises a strain inducing layer for inducing compressive or tensile strain in at least one of the first and second electrode layers to thereby induce the collinear ferrimagnetic structure therein.

13. The magnetic device of any preceding claim, wherein at least one of the first and second magnetic electrode layers has a nitrogen deficiency; and/or
wherein the first magnetic electrode layer and second magnetic electrode layer have a thickness of 100 nm or less, and preferably a thickness of 50 nm or less.

14. The magnetic device of any preceding claim, wherein the space group of the spacer layer, and the first magnetic electrode layer and second magnetic electrode layer are the same; and/or
wherein a lattice mismatch between the spacer layer, and the first magnetic electrode layer and second magnetic electrode layer is less than ±10%, preferably less than ±1%.

15. A memory cell used for memory or storage devices comprising the magnetic device of any of claims 1 to 14, wherein data is recordable as a parallel and antiparallel net magnetisation state of the first magnetic electrode layer and second magnetic electrode layer of the magnetic device.
